# EUROPEAN PATENT SPECIFICATION

(11) **EP 3 900 501 B1**
(45) Date of publication and mention of the grant of the patent: **04.02.2026**
(21) Application number: 19817264.5
(22) Date of filing: 06.12.2019
(51) Int. Cl.: H05K 7/20

(54) **AN ARRANGEMENT FOR COOLING POWER SEMICONDUCTOR DEVICES OF A CONVERTER**
ANORDNUNG ZUR KÜHLUNG VON LEISTUNGSHALBLEITERBAUELEMENTEN EINES UMRICHTERS
AGENCEMENT POUR REFROIDIR DES DISPOSITIFS À SEMI-CONDUCTEURS DE PUISSANCE D'UN CONVERTISSEUR

(30) Priority: 18.12.2018 SE 1851602
(43) Date of publication of application: 27.10.2021
(60) Divisional application: 25220127.2
(73) Proprietor: ALSTOM Holdings, 93400 Saint-Ouen-sur-Seine (FR)
(72) Inventor: DIEDRICHS, Ben, 172 40 Sundbyberg (SE); RANDOW, Tommy, 723 50 Västerås (SE)
(74) Representative: Bjerkén Hynell KB
(86) International application number: PCT/EP2019/083979
(87) International publication number: WO 2020/126548

(56) References cited:
- EP-A1- 0 794 098
- EP-A1- 2 950 625
- WO-A1-2009/063619
- WO-A1-2018/020615
- GB-A- 2 534 013
- US-A1- 2015 219 348
- US-A1- 2016 091 264

## Description

### TECHNICAL FIELD OF THE INVENTION AND BACKGROUND ART

The present invention relates to an arrangement for cooling power semiconductor devices of a converter arranged in a closed casing with said semiconductor devices in a bottom of the casing on top of a heat sink having members, such as fins, for heat exchange extending externally of the casing out from the bottom, the arrangement comprising:
- a channel for conducting a flow of air to pass said members for cooling thereof, in which a first portion of said channel has the casing bottom as a ceiling and receiving said members, and
- a fan located with a suction side connected to said first channel portion to create a flow of air from an inlet from the exterior into said channel while passing the heat sink members.

The invention is not restricted to any particular field of use of a said converter, but the use thereof in a railway vehicle, such as in the form of line converters, motor converters and auxiliary converters, will in some parts of this disclosure be discussed for illuminating the invention but accordingly not restrict the invention thereto.

The power semiconductor devices may for example be IGBTs or MOSFETs. The converter is enclosed in a said casing for protecting the components thereof against dust and debris. This casing will then also contain electronic equipment among other used for the control of the converter. This content of the casing generates waste heat that needs to be rejected out of the casing, which for the heat generated by the power semiconductor devices is mainly obtained by conducting a flow of air to pass the members of the heat sink upon which the semiconductor devices of the converter are arranged. Known arrangements of the type defined in the introduction for cooling the power semiconductor devices through such an air flow do not operate as efficiently as desired, and in case of being on board a railway vehicle there is not only a problem with an increased consumption of energy would it be tried to increase the power of the fan for improving the cooling, but that measure is only possible to a certain degree because too powerful and disturbing noise would otherwise be generated by the oneration of the fan.

WO 2018/020615 A1 discloses an arrangement for cooling a power conversion device.

### SUMMARY OF THE INVENTION

The object of the present invention is to provide an arrangement of the type defined in the introduction addressing the problem mentioned above of such arrangements already known.

This object is according to the invention obtained by providing such an arrangement according to claim 1.

Thus, the fan is provided with an inlet cone arranged to allow air to be drawn all around the inlet of the cone into the fan. Such an inlet cone will remarkably increase the maximum flow of air through the channel obtainable through the operation of the fan and by that the efficiency of the cooling of the semiconductor devices of the converter.

According to an embodiment of the invention the inlet cone tapers towards an inlet of the fan symmetrically with respect to an axis being perpendicular to the inlet of the fan. The fan will by this operate with a high efficiency.

According to the embodiment of the invention the fan is arranged with said inlet cone being symmetrical with respect to a vertical axis to obtain an air flow vertically, such as from below, into the fan, and the channel has a third channel portion connecting to the first channel portion while changing direction of the channel by 90° or substantially 90° while forming said inlet cone. Such an arrangement of the fan in combination with a said inlet cone is advantageous. The fan may by this be arranged beside or behind the converter casing for obtaining a compact construction of converter and arrangement. In the case of having the arrangement in a railway vehicle, in which the converter casing may be arranged under the car body, an arrangement of the fan to have an air flow vertically from below into the fan, will be advantageous for considering the reduced space available.

According to another embodiment of the invention the arrangement is configured to cool power semiconductor devices of two said converters arranged in a said casing each and having a said channel with a said inlet each, and the two channels have a said fan in common with the casings arranged on opposite sides of the fan to have first channel portions reaching the inlet cone of the fan from opposite directions so as to draw air all around the inlet cone into the fan. Such a positioning of the fan and having one fan for obtaining cooling of the power semiconductor devices of both converters results in a maximized air flow through the fan by the uniform air flow into the inlet thereof and by that a possibility to use only one fan of a certain rating and still obtain sufficient cooling of the semiconductor devices of two converters.

According to the embodiment of the invention the channel is provided with a second portion connected to the first portion as seen in the direction of the air flow through the channel upstreams of the first portion and the second channel portion extends along and has as a delimiting wall a lateral wall of the casing connecting to the bottom thereof to conduct air downwards along this lateral casing wall to enter the first channel portion. Furthermore, the channel inlet is located in the second channel portion opposite to the lateral casing wall and has a longitudinal extension in the direction of the extension of this channel portion to the region of the start of the first channel portion. This way of arranging the inlet makes it possible to obtain a large area of the channel inlet, so that the speed of the air therethrough will not exceed the maximum speed of air through the filter media allowable for ensuring that dust and debris are not drawn through the filter and resulting in a low air pressure drop through the filter and by that a maximum flow obtainable through the operation of the fan through the channel.

According to another embodiment of the invention the second channel portion has a cross-section increasing in the direction of the extension towards the first channel portion. This makes it possible to increase the filter area and by that fully utilize the performance of the fan and is also favourable for obtaining a uniform speed of the air flow in the second channel portion and by that also in the first channel portion.

According to another embodiment of the invention the filter is diverging away from the lateral casing wall in the direction of the extension of the second channel portion towards the first channel portion, through which the filter area may increase.

According to another embodiment of the invention the arrangement comprises an air-to-air heat exchanger with surfaces covering said lateral casing wall and forming a wall part of the second channel portion heated by a flow of air heated by components inside the casing and to be cooled by air flowing downwards therealong in the second channel portion. A possible linear or nearly linear vertical pressure drop in the second channel portion and a uniform flow therein resulting therefrom will result in a uniform efficient cooling of said surfaces of the heat exchanger to remove heat generated by electronics inside the casing from the casing.

The invention also relates to a use of an arrangement according to the invention for cooling power semiconductor devices of a converter in a railway vehicle, in which the arrangement according to an embodiment thereof is mounted under the car body of a railway vehicle. The invention also relates to a railway vehicle provided with an arrangement according to the invention.

Further advantages as well as advantageous features of the invention will appear from the description following below.

### BRIEF DESCRIPTION OF THE DRAWINGS

With reference to the appended drawings, below follows a specific description of an embodiment of the invention cited as an example.

In the drawings:
- Fig 1: is a very schematic view illustrating the general construction of an arrangement for cooling power semiconductor devices of a converter according to an embodiment of the invention, and
- Fig 2: is a view in the direction of the arrow I in Fig 1 on the channel inlet of the arrangement shown in Fig 1.

### DETAILED DESCRIPTION OF AN EMBODIMENT OF THE INVENTION

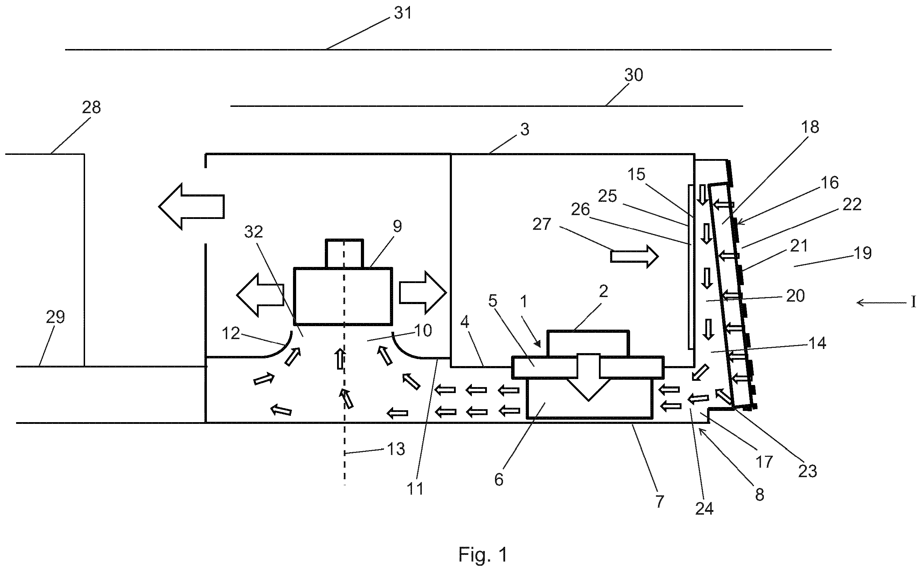

It is shown in Fig 1 how a converter 1 having power semiconductor devices 2 illustrated by a box are arranged in a closed casing 3 in the form of a so-called converter box. The semiconductor devices, which are for instance IGBTs or MOSFETs, are arranged in the bottom 4 of the casing on top of a heat sink 5 having fins 6 for heat exchange extending externally of the casing down from the bottom 4 into a first portion 7 of a channel 8 for conducting a flow of air to pass the fins. This first channel portion has the casing bottom (partly provided by the heat sink) as a ceiling.

A fan 9 is arranged with a suction side 10 connected to the first channel portion 7 through a third channel portion 11 being a part of an inlet cone 12 of the fan, which is symmetrical with respect to a vertical axis 13 to obtain an air flow from below vertically into the fan while changing the direction of the channel by 90° with respect to the direction thereof through the first channel portion 7.

The channel further comprises a second portion 14 connected to the first portion 7 as seen in the direction of the air flow through the channel upstreams of the first portion. This second channel portion extends along and has as a delimiting wall a lateral wall 15 of the casing 3 connecting to the bottom 4 to conduct air down-wards along the lateral casing wall to enter the first channel portion 7.

A channel inlet 16 is located in the second channel portion 14 opposite to the lateral casing wall 15 and has a longitudinal extension in the direction of the extension of this channel portion to the region of the start 17 of the first channel portion 7. A filter 18 covers the channel inlet 16 for removal of dust and debris from air entering the channel from the exterior 19.

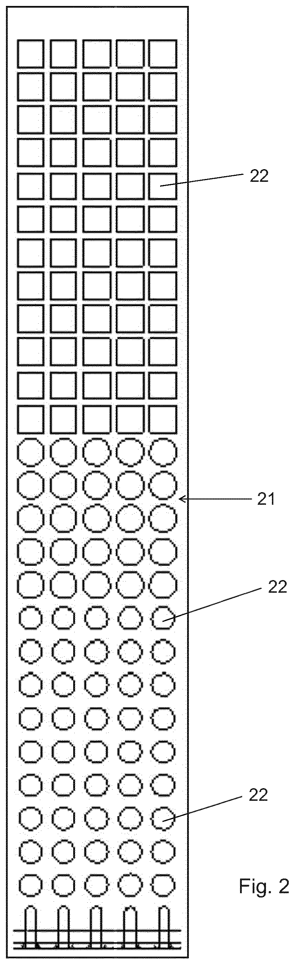

The channel inlet 16 is designed to form a resistance to flow of air therethrough through the filter 18 and into the second channel portion 14 increasing in the direction towards the first channel portion 7 so as to in this direction increase the air pressure difference between the exterior 19 and the inner 20 of the second channel portion and by that reduce the air flow into the second channel portion the closer the second channel portion comes to the start 17 of the first channel portion. This is obtained by having an air-impermeable channel wall member 21 in the form of a so-called inlet grill arranged outside the filter and provided with through-holes 22 for air to pass and varying the size of these through-holes to decrease in subsequent sections of the second channel portion the closer the section is to the start 17 of the first channel portion. It is shown in Fig 2 how the total area of the through-holes 22 in subsequent sections of the second channel portion decreases in the direction towards the first channel portion. This design of the channel inlet will result in a linear vertical pressure drop and uniform flow of air in the second channel portion 14 and by that through the entire channel.

The second channel portion 14 has a cross-section increasing in the direction of the extension thereof towards the first channel portion 7 by having the filter 18 and the channel wall member 21 diverging away from the lateral casing wall 15 in the direction of the extension of the second channel portion towards the first channel portion. This results in a possibility to increase the area of the filter and by that the fan performance without exceeding the maximum speed of air through the filter ensuring that no dust or debris is drawn through the filter.

The channel inlet has also openings 23 into the channel in the region of the start 17 of the first channel portion from below to create a flow of air into the region of the junction 24 of the second channel portion 14 to the first channel portion 7 from below. These openings ensure that the air flow in the first channel portion will be uniform into and about the fins 6 in the vertical direction of the cross-section of the first channel portion.

The converter casing 3 further contains electronics for among others the control of the converter and conducting rails generating power losses in the form of heat, and the casing does for that sake contain an air to air heat exchanger 25 with surfaces 26 covering the lateral casing wall 15 and forming a wall part of the second channel portion heated by a flow of air inside the casing heated by said power loss heat inside the casing to be cooled by air flowing downwards therealong in the second channel portion. A member causing such an air flow inside the heat exchanger 25 is indicated by the arrow 27. The linear vertical pressure drop inside the second channel portion resulting in a constant air flow passing the heat exchanger 25 results in a uniform cooling of the entire surfaces 26 thereof.

It is indicated in Fig 1 how the casing 28 of a further converter with power semiconductor devices may be arranged to have a corresponding design of channel as shown to the right in Fig 1 with a first channel portion 29 thereof connecting to the inlet cone 12 of the fan 9, which will then be in common to cooling power semiconductor devices of both converters. This means that the first channel portions 7, 29 will reach the inlet cone 12 of the fan 9 from opposite directions so as to draw air all around the inlet cone into the fan while optimizing the performance of the fan, so that the power rating of the fan will be utilized to full extent for cooling the semiconductor devices of the converters.

It is very schematically indicated how the converter casings with the arrangement for cooling the power semiconductor devices thereof may be mounted under the car body 30 of a railway vehicle 31 where a filter 18 is absolutely necessary for preventing dust and debris from reaching into the channel used for cooling purposes.

The invention is of course in no way restricted to the embodiment described above, since many possibilities for modifications thereof are likely to be obvious to one skilled in the art without having to deviate from the scope of the invention defined in the appended claims.

It is of course possible to incline the entire construction arbitrarily with respect to what is shown in Fig 1, so that the bottom of the converter casing forming the ceiling of the first channel portion does not extend horizontally or even substantially horizontally, and the wording of this disclosure with respect to orientation of different parts in the space is configured to cover such modifications. For instance may everything be turned upside down, and the bottom of the casing will then be the casing part on the highest level and the heat sink members, such as fins, will then extend upwards out from the bottom. Thus, "bottom" as used in this disclosure is to be interpreted to cover any orientation of that casing part. "Lateral" as used in this disclosure relates to the bottom, so that if the bottom extend vertically said lateral casing wall may extend nearly horizontally. This do then also mean that the definition "being symmetrical with respect to a vertical axis" will then also be met by a said axis being not exactly vertical owing to a tilting of the entire construction.

## Claims

1. An arrangement for cooling power semiconductor devices (2) of a converter (1) whereby the converter is arranged in a closed casing (3) having a casing bottom (4) and a lateral casing wall (15), with said semiconductor devices in said casing bottom (4) of the casing on top of a heat sink (5) having members (6), such as fins, for heat exchange extending externally of the casing out from the casing bottom, the arrangement comprising:
an inlet (16),
a channel (8) for conducting a flow of air to pass said members (6) for cooling thereof, in which a first channel portion (7) of said channel is arranged to have the casing bottom (4) as a ceiling and arranged for receiving said members,
a fan (9) located with a suction side connected to said first channel portion (7) arranged to create the flow of air from the inlet (16) from the exterior (19) into said channel while passing the members (6), and
a filter (18) covering said inlet (16) to the channel (8) for removal of dust and debris from air entering the channel from the exterior (19),
wherein the fan (9) is provided with an inlet cone (12) arranged to allow air to be drawn all around the inlet of the cone into the fan,
wherein the inlet cone (12) tapers towards an inlet (32) of the fan (9) symmetrically with respect to an axis (13) being perpendicular to the inlet (32) of the fan (9),
wherein the fan (9) is arranged with said inlet cone (12) being symmetrical with respect to a vertical axis (13) to obtain an air flow vertically into the fan, and
wherein the channel (8) has a third channel portion (11) being a part of the inlet cone, the third channel portion connecting to the first channel portion (7) while changing direction of the channel by 90° or substantially 90° with respect to the direction thereof through the first channel portion, **characterized in that** the channel (8) comprises a second portion (14) connected to the first portion (7) as seen in the direction of the air flow through the channel upstream of the first portion, wherein the second channel portion (14) extends along and is arranged to have as a delimiting wall the lateral casing wall (15) of said casing (3) and the second channel portion is arranged to connect to said casing bottom (4) of said casing (3) to conduct air downwards along this lateral casing wall (15) to enter the first channel portion (7), and wherein inlet (16) is located in the second channel portion (14) opposite to said lateral casing wall (15) of said casing (3) and has a longitudinal extension in the direction of the extension of the second channel portion to a region of the start (17) of the first channel portion (7).

2. An arrangement according to claim 1, **characterized in that** the fan (9) is arranged with the inlet cone (12) pointing upwards so as to obtain an air flow from below vertically or substantially vertically into the fan.

3. An arrangement according to claim 2, **characterized in that** it is configured to cool power semiconductor devices (2) of two said converters arranged in a said casing (3, 28) each and having a said channel with a said inlet each, and that the two channels have a said fan (9) in common with the casings (3, 28) arranged on opposite sides of the fan (9) to have first channel portions (7, 29) reaching the inlet cone (12) of the fan from opposite directions so as to draw air all around the inlet cone into the fan.

4. An arrangement according to any of claims 1 to 3, **characterized in that** the second channel portion (14) has a cross-section increasing in the direction of the extension thereof towards the first channel portion (7).

5. An arrangement according to claim 4, **characterized in that** the filter (18) is diverging away from said lateral casing wall (15) in the direction of the extension of the second channel portion (14) towards the first channel portion (7).

6. An arrangement according to any of claims 4-5, **characterized in that** it comprises an air to air heat exchanger (25) with surfaces (26) covering said lateral casing wall (15) and forming a wall part of the second channel portion (14) heated by a flow of air heated by components inside the casing (3) and to be cooled by air flowing down-wards therealong in the second channel portion.

7. Use of an arrangement according to any of the preceding claims for cooling power semiconductor devices (2) of a converter (1) in a railway vehicle (31).

8. A use according to claim 7, **characterized in that** the arrangement is mounted under the car body (30) of a railway vehicle (31).

9. A railway vehicle, **characterized in that** it is provided with an arrangement according to any of claims 1-6.

## Patentansprüche

1. Eine Anordnung zur Kühlung von Leistungshalbleiterbauelementen (2) eines Umrichters (1), wobei der Umrichter in einem geschlossenen Gehäuse (3) angeordnet ist, das einen Gehäuseboden (4) und eine seitliche Gehäusewand (15) aufweist, wobei die Halbleiterbauelemente in dem Gehäuseboden (4) des Gehäuses auf einem Kühlkörper (5) angeordnet sind, der Elemente (6), wie z. B. Rippen, zum Wärmeaustausch aufweist, die sich außerhalb des Gehäuses vom Gehäuseboden aus erstrecken, wobei die Anordnung umfasst:
einen Einlass (16),
einen Kanal (8) zur Führung eines Luftstroms, um die Elemente (6) zu deren Kühlung zu passieren, wobei ein erster Kanalabschnitt (7) des Kanals so angeordnet ist, dass der Gehäuseboden (4) eine Decke bildet, und zur Aufnahme der Elemente angeordnet ist,
einen Lüfter (9), der mit einer Saugseite mit dem ersten Kanalabschnitt (7) verbunden und so angeordnet ist, dass er den Luftstrom vom Einlass (16) von außen (19) in den Kanal erzeugt, während er die Elemente (6) passiert, und
einen Filter (18), der den Einlass (16) zum Kanal (8) abdeckt, zur Entfernung von Staub und Schmutz aus der Luft, die von außen (19) in den Kanal eintritt,
wobei der Lüfter (9) mit einem Einlasskonus (12) versehen ist, der so angeordnet ist, dass Luft rings um den Einlass des Konus in den Lüfter gesaugt werden kann,
wobei sich der Einlasskonus (12) zu einem Einlass (32) des Lüfters (9) symmetrisch zu einer Achse (13) verjüngt, die senkrecht zum Einlass (32) des Lüfters (9) steht,
wobei der Lüfter (9) mit dem Einlasskonus (12) symmetrisch zu einer vertikalen Achse (13) angeordnet ist, um einen vertikalen Luftstrom in den Lüfter zu erhalten, und
wobei der Kanal (8) einen dritten Kanalabschnitt (11) aufweist, der Teil des Einlasskonus ist, wobei der dritte Kanalabschnitt mit dem ersten Kanalabschnitt (7) verbunden ist, während er die Richtung des Kanals um 90° oder im Wesentlichen 90° bezüglich der Richtung durch den ersten Kanalabschnitt ändert, **dadurch gekennzeichnet, dass** der Kanal (8) einen zweiten Abschnitt (14) umfasst, der mit dem ersten Abschnitt (7) verbunden ist, gesehen in Richtung des Luftstroms durch den Kanal stromaufwärts des ersten Abschnitts,
wobei sich der zweite Kanalabschnitt (14) entlang der seitlichen Gehäusewand (15) des Gehäuses (3) erstreckt und so angeordnet ist, dass diese seine Begrenzungswand bildet, und der zweite Kanalabschnitt
so angeordnet ist, dass er mit dem Gehäuseboden (4) des Gehäuses (3) verbunden ist, um Luft entlang dieser seitlichen Gehäusewand (15) nach unten zu leiten, damit sie in den ersten Kanalabschnitt (7) eintritt, und
wobei der Einlass (16) sich in dem zweiten Kanalabschnitt (14) gegenüber der seitlichen Gehäusewand (15) des Gehäuses (3) befindet und eine Längserstreckung in Richtung der Erstreckung des zweiten Kanalabschnitts bis zu einem Bereich des Beginns (17) des ersten Kanalabschnitts (7) aufweist.

2. Anordnung nach Anspruch 1, **dadurch gekennzeichnet, dass** der Lüfter (9) mit dem Einlasskonus (12) nach oben weisend angeordnet ist, um einen Luftstrom von unten vertikal oder im Wesentlichen vertikal in den Lüfter zu erhalten.

3. Anordnung nach Anspruch 2, **dadurch gekennzeichnet, dass** sie so konfiguriert ist, dass sie Leistungshalbleiterbauelemente (2) von zwei solchen Umrichtern kühlt, die jeweils in einem Gehäuse (3, 28) angeordnet sind und jeweils einen solchen Kanal mit einem solchen Einlass aufweisen, und dass die beiden Kanäle einen Lüfter (9) gemeinsam haben, wobei die Gehäuse (3, 28) auf gegenüberliegenden Seiten des Lüfters (9) angeordnet sind, sodass erste Kanalabschnitte (7, 29) den Einlasskonus (12) des Lüfters aus entgegengesetzten Richtungen erreichen, um Luft rings um den Einlasskonus in den Lüfter zu saugen.

4. Anordnung nach einem der Ansprüche 1 bis 3, **dadurch gekennzeichnet, dass** der zweite Kanalabschnitt (14) einen Querschnitt aufweist, der in Richtung seiner Erstreckung zum ersten Kanalabschnitt (7) hin zunimmt.

5. Anordnung nach Anspruch 4, **dadurch gekennzeichnet, dass** der Filter (18) von der seitlichen Gehäusewand (15) in Richtung der Erstreckung des zweiten Kanalabschnitts (14) zum ersten Kanalabschnitt (7) hin divergiert.

6. Anordnung nach einem der Ansprüche 4-5, **dadurch gekennzeichnet, dass** sie einen Luft-Luft-Wärmetauscher (25) mit Oberflächen (26) umfasst, die die seitliche Gehäusewand (15) abdecken und einen Wandteil des zweiten Kanalabschnitts (14) bilden, der durch einen Luftstrom, der durch Komponenten im Inneren des Gehäuses (3) erwärmt wird, beheizt wird und durch Luft, die im zweiten Kanalabschnitt daran entlang nach unten strömt, gekühlt werden soll.

7. Verwendung einer Anordnung nach einem der vorangehenden Ansprüche zur Kühlung von Leistungshalbleiterbauelementen (2) eines Umrichters (1) in einem Schienenfahrzeug (31).

8. Verwendung nach Anspruch 7, **dadurch gekennzeichnet, dass** die Anordnung unter dem Wagenkasten (30) eines Schienenfahrzeugs (31) montiert ist.

9. Schienenfahrzeug, **dadurch gekennzeichnet, dass** es mit einer Anordnung nach einem der Ansprüche 1-6 versehen ist.

## Revendications

1. Agencement pour refroidir des semi-conducteurs de puissance (2) d'un convertisseur (1), moyennant quoi le convertisseur est agencé dans un boîtier fermé (3) ayant un fond de boîtier (4) et une paroi de boîtier latérale (15), lesdits semi-conducteurs dans ledit fond de boîtier (4) du boîtier étant au-dessus d'un dissipateur thermique (5) ayant des organes (6), tels que des ailettes, pour un échange thermique s'étendant en externe hors du boîtier à partir du fond de boîtier, l'agencement comprenant :
une entrée (16),
un canal (8) pour conduire un écoulement d'air pour qu'il passe lesdits organes (6) afin de les refroidir, dans lequel une première portion de canal (7) dudit canal est agencée pour avoir le fond de boîtier (4) comme
un plafond et agencé pour recevoir lesdits organes,
un ventilateur (9) situé avec un côté d'aspiration raccordé à ladite première portion de canal (7) agencé pour créer l'écoulement d'air depuis l'entrée (16) depuis l'extérieur (19) jusque dans
ledit canal tout en passant les éléments (6), et
un filtre (18) recouvrant ladite entrée (16) vers le canal (8) pour l'élimination de la poussière et des débris provenant de l'air entrant dans le canal depuis l'extérieur (19),
dans lequel le ventilateur (9) est muni d'un cône d'entrée (12) agencé pour permettre à l'air d'être aspiré tout autour de l'entrée du cône jusque dans le ventilateur,
dans lequel le cône d'entrée (12) s'effile vers une entrée (32) du ventilateur (9) symétriquement par rapport à un axe (13) perpendiculaire à l'entrée (32) du ventilateur (9),
dans lequel le ventilateur (9) est agencé avec ledit cône d'entrée (12) qui est symétrique par rapport à un axe vertical (13) pour obtenir un écoulement d'air verticalement dans le ventilateur, et dans lequel le canal (8) a une troisième portion de canal (11) faisant partie du cône d'entrée, la troisième portion de canal se raccordant à la première portion de canal (7) tout en changeant la direction du canal de 90° ou sensiblement 90° par rapport à la direction de celui-ci à travers la première portion de canal, **caractérisé en ce que**
le canal (8) comprend une deuxième portion (14) raccordée à la première portion (7) telle que vue dans la direction de l'écoulement d'air à travers le canal en amont de la première portion, dans lequel la deuxième portion de canal (14) s'étend le long de la paroi de boîtier latérale (15) dudit boîtier (3) et est agencée pour avoir celle-ci comme paroi de délimitation et la deuxième portion de canal est agencée pour se raccorder audit fond de boîtier (4) dudit boîtier (3) pour conduire l'air vers le bas le long de cette paroi de boîtier latérale (15) pour entrer dans la première portion de canal (7), et dans lequel l'entrée (16) est située dans la deuxième portion de canal (14) à l'opposé de ladite paroi de boîtier latérale (15) dudit boîtier (3) et a une extension longitudinale dans la direction de l'extension de la deuxième portion de canal vers une région du départ (17) de la première portion de canal (7).

2. Agencement selon la revendication 1, **caractérisé en ce que** le ventilateur (9) est agencé avec le cône d'entrée (12) orienté vers le haut de manière à obtenir un écoulement d'air depuis le dessous verticalement ou sensiblement verticalement jusque dans le ventilateur.

3. Agencement selon la revendication 2, **caractérisé en ce qu'**il est configuré pour refroidir des semi-conducteurs de puissance (2) de deux desdits convertisseurs agencés chacun dans un dit boîtier (3, 28) et ayant chacun un dit canal avec une dite entrée, et **en ce que** les deux canaux ont un dit ventilateur (9) en commun avec les boîtiers (3, 28) agencés sur des côtés opposés du ventilateur (9) pour avoir des premières portions de canal (7, 29) atteignant le cône d'entrée (12) du ventilateur à partir de directions opposées de manière à aspirer de l'air tout autour du cône d'entrée dans le ventilateur.

4. Agencement selon l'une quelconque des revendications 1 à 3, **caractérisé en ce que** la deuxième portion de canal (14) a une coupe transversale qui augmente dans la direction de son extension vers la première portion de canal (7).

5. Agencement selon la revendication 4, **caractérisé en ce que** le filtre (18) diverge à partir de ladite paroi de boîtier latérale (15) dans la direction de l'extension de la deuxième portion de canal (14) vers la première portion de canal (7).

6. Agencement selon l'une quelconque des revendications 4 et 5, **caractérisé en ce qu'**il comprend un échangeur thermique air-air (25) avec des surfaces (26) recouvrant ladite paroi de boîtier latérale (15) et formant une partie de paroi de la deuxième portion de canal (14) chauffée par un écoulement d'air chauffé par des composants à l'intérieur du boîtier (3) et devant être refroidie par de l'air s'écoulant vers le bas le long de celui-ci dans la deuxième portion de canal.

7. Utilisation d'un agencement selon l'une quelconque des revendications précédentes pour refroidir des semi-conducteurs de puissance (2) d'un convertisseur (1) dans un véhicule ferroviaire (31).

8. Utilisation selon la revendication 7, **caractérisée en ce que** l'agencement est monté sous la caisse (30) d'un véhicule ferroviaire (31).

9. Véhicule ferroviaire, **caractérisé en ce qu'**il est muni d'un agencement selon l'une quelconque des revendications 1 à 6.
